# EUROPEAN PATENT SPECIFICATION

(11) **EP 3 633 844 B1**
(45) Date of publication and mention of the grant of the patent: **21.07.2021**
(21) Application number: 18198556.5
(22) Date of filing: 04.10.2018
(51) Int. Cl.: H02N 2/18

(54) **AUTONOMOUS PIEZOELECTRIC POWER GENERATOR**
AUTONOMER PIEZOELEKTRISCHER ENERGIEGENERATOR
GÉNÉRATEUR D'ÉNERGIE PIÉZOÉLECTRIQUE AUTONOME

(43) Date of publication of application: 08.04.2020
(73) Proprietor: Tridonic GmbH & Co. KG, 6851 Dornbirn (AT)
(72) Inventor: Wilson, Ian, Sunderland, SR33RH (GB)
(74) Representative: Beder, Jens

(56) References cited:
- WO-A1-2008/103932
- WO-A1-2009/065411
- WO-A1-2013/083990
- DE-A1-102004 030 442
- GB-A- 588 535
- US-A- 2 588 348

## Description

The present invention relates to a method and system for providing electric energy for an electric device, such as a sensor of a lighting system or an emergency light.

Many devices use a battery or solar cells for independent energy supply. However, batteries must be charged or replaced and solar cells often supply energy discontinuously.

EP 2 481 979 A1 discloses a lamp with an autonomous power generator system, which uses lighting and thermal power of the sun and air pressure generated by passing vehicles to provide electricity to the lamp. Because of the various power sources, a stable and continuous energy supply can be ensured. However, this system is complex and expensive.

WO 2009/065411 A1 discloses a system and corresponding method for generating electrical energy according to the preambles of the independent claims, comprising a bellows system which expands or contracts based on changes of environmental conditions, at least one piezoelectric generator element elastically deformable by the bellows movement, a storage capacitor or battery, and a charging unit therefore. Either two piezoelectric strips are stretched or a piezoelectric cantilever is bent by the bellows, for example. DE 10 2004 030442 A1 describes a similar generator system, wherein a thermal expansion driven bellows compresses an annular piezo element which directly powers a sender.

WO 2008/103932 A1 exemplifies control of a charging unit for optimizing power extraction from a piezo generator, wherein a switch arranged between a rectifier connected to a piezo and an inductor connected to a storage capacitor is closed when the piezo voltage exceeds a certain threshold and some conditions are met, and the switch is opened based on other conditions.

It is an object of the present invention to overcome the above-mentioned drawbacks and to provide an improved power generating system. More specifically, it is an object of the invention to provide a system and method, with which a stable and continuous energy supply can be ensured with low effort and costs.

This object is achieved by a system and a method according to the enclosed independent claims. Advantageous features of the present invention are defined in the corresponding subclaims.

According to the present invention, the power is generated by changes in environmental conditions. Such changes advantageously are changes in atmospheric pressure and/or temperature and comprises a bellow system, in which the bellow expands or contracts based on temperature changes and/or atmospheric pressure changes. It could even be thought of using changes in humidity or lighting conditions. The system further includes a piezo generator, that generates electric energy by a piezoelectric element elastically deformed by the movement of the expanding or contracting bellow.

Since changes in atmospheric pressure and/or temperature usually occur during the course of the day or at least changing weather conditions, a stable and continuous energy supply can be ensured, especially for smaller energy consumers, using only a few components. The changes in environmental conditions are always available. Of course, the gradient of the changes may change, but nevertheless at least a small movement will be generated that is sufficient to produce electric energy by the piezo.

The bellow system can comprise a hermetically sealed bellow filled with a gas and/or a liquid, which expands or contracts considerably due to a change of temperature and/or pressure.

Preferably, the bellow includes or is filled with liquid and gaseous ethyl chloride having a boiling point around 12 °C. This ensure that the ration of the liquid an gaseous portion rather rapidly changes, which ensures efficient electric energy generation. Of course other gases and liquid my be used as well, but it is preferred, that their boiling point is in the range of 8°C to 16°C, preferred 10°C to 14°C. The boiling point is referred to under normal conditions.

Alternatively or in addition, the system can comprise a return spring actuating biasing the piezoelectric element and/or the bellow in order to counteract to the movement that is generated by the bellow system.

A movement is transferred to the piezoelectric element, when bellow expands or contracts continuously. To increase the energy generated by the piezoelectric element, the system can comprise a mechanical converter that increases the frequency of movements applied to the piezoelectric element. The mechanical converter has an input member mechanically coupled to the bellow and moved by the expanding or contracting bellow and is configured to convert one stroke of the input member into a reciprocal movement applied to the piezoelectric element.

Further, the generator may comprise a plurality of piezo generators and/or a plurality of bellow systems, wherein each bellow system provides movements for one or more piezoelectric elements.

In addition, the system comprises a capacitor or a battery for storing the electric energy generated by the piezo generator and a charging unit for charging the capacitor or the battery by the generated electric energy, characterised by a control unit for controlling the charging unit according to the independent claim 1.

In addition, the control unit for controlling the charging unit can activate the charging when the level of the electric energy generated by the piezo generator exceeds a first threshold.

Preferably, a sensor with low energy consumption can be supplied with energy from the system. According to the present invention, the sensor comprises at least one of the systems described above.

According to the present invention, the method for generating electric energy comprises the steps of:
- generating a movement by an expanding or contracting a bellow of a bellow system based on changes of environmental conditions, especially temperature and/or atmospheric pressure changes; and
- generating electric energy by deforming a piezoelectric element of a piezo generator by applying the movement to the piezoelectric element.

In addition, a reciprocal movement may be applied to the piezoelectric element, wherein the method further comprises the step of modulating the movement generated by the bellow into said reciprocal movement.

The method further comprises a step of charging a capacitor or a battery by the generated electric energy, according to the independent claim 8.

The method can further comprise the step of activating the charging when the level of the electric energy generated by the piezo generator exceeds a first threshold.

Aspects and details of the invention are now explained with reference to the accompanying drawings, wherein:
FIG. 1 shows a system according to the prior art,
FIG. 2 shows a system according to an embodiment of the present invention,
FIG. 3 shows a system according to a further embodiment of the present invention,
FIG. 4 shows a mechanical converter in an embodiment of the present invention,
FIG. 5 shows a sensor device supplied with electric energy by yet another embodiment of the present invention, and
FIG. 6 shows a flowchart of the method according to an embodiment of the present invention. The same features are denoted in the figures by the same reference signs.

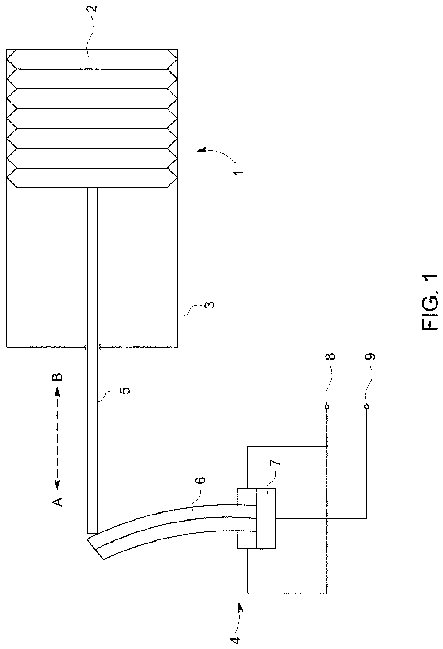

FIG. 1 shows a schematic structural diagram of a power generating system known from the aforementioned document. The power generating system shown in FIG. 1 comprises a bellow system 1 having a bellow 2 (pressure cell) located in a cylinder 3, a piezo generator 4 and a piston 5 that connects the piezo generator 3 with the bellow 2. The bellow is hermetically sealed and preferably filled with ethyl chloride C₂H₅Cl, which is a gas at room temperature but exists in both liquid and gaseous states in the hermetically sealed bellow 2. The ethyl chloride vaporizes as the temperature rises above and condenses with a fall in temperature below its boiling point. The cylinder 3 is not hermetically sealed and filled with atmospheric air.

Pressure in the bellow 2 depends on ambient temperature and (to a certain degree) on atmospheric pressure, wherein pressure increases as temperature rises and, as a consequence, the bellow 2 expands in the direction "A" of the double arrow shown in FIG. 1. Similarly, pressure decreases as temperature drops and the bellow 2 contracts in the direction "B" of the double arrow.

The piezo generator 4 comprises a piezoelectric element 6 fixed to a base 7 and output connectors 8, 9, that output the voltage/energy generated by the piezoelectric bending element 6 when its structure is deformed (bent, as shown in the figures). The piezoelectric element 6 shown in FIG. 1 is bent in direction "A" by the piston 5 when the bellow 2 moves the piston 5 in the direction "A" and therefore, applies a respective movement on the piezoelectric bending element 6 via the piston 5 which causes a force on the piezo element finally generating a voltage.

Even if the power generator system is installed outside, the system generates electrical energy consistently because of changes in temperature which continuously changes during the course of the day. The same is true for other environmental conditions.

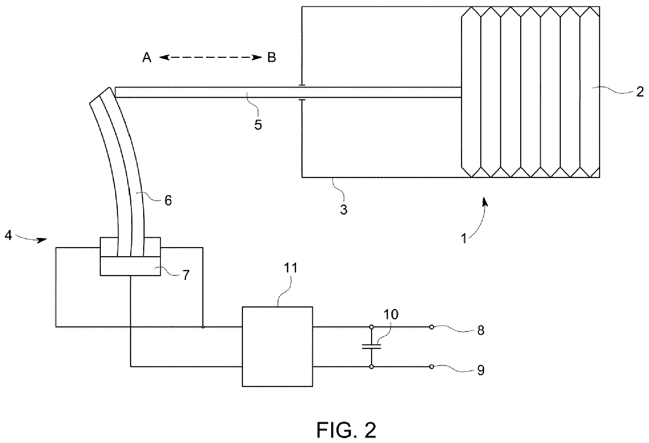

In order to compensate fluctuations in the generation and/or consumption of energy, the system comprises a storage means that stores/buffers the generated energy. The system shown in FIG. 2 further contains a capacitor 10 connected in parallel to the output connectors 8, 9 and a charging unit 11 for charging the capacitor 10. The charging unit 11 comprises a converter (not shown), for example a charge pump or boost-converter, that converts the voltage generated by the piezoelectric bending element 6 into the charging voltage and a control unit that controls the charging operation.

The control unit activates charging when the level of electric energy (voltage) generated by the piezoelectric bending element 6 exceeds a first threshold and/or the energy stored in the capacitor 10 falls below a second threshold and deactivates the charging when the level of the electric energy generated by the piezoelectric bending element 6 is below or equal to the first threshold and/or the energy stored in the capacitor 10 exceeds a third threshold. The first threshold is set based on efficiency of the converter so that the output power of the piezoelectric bending element 6 generated during the charging operation is higher than the power loss of the converter. The second threshold and/or third threshold are set based on the capacitance of the capacitor 10 and the power consumption of a device connected to the output connectors 8, 9.

In addition, a temporal profile of the power consumption and/or the energy generated by the piezoelectric bending element 6 is inputted in or predicted by the control unit, wherein the temporal profile indicates the expected power consumption and/or production throughout the day or over another period of time and the control unit sets the second threshold and/or third threshold based on the temporal profile(s) in order to match the energy requirements of the connected device and the available energy of the system each time.

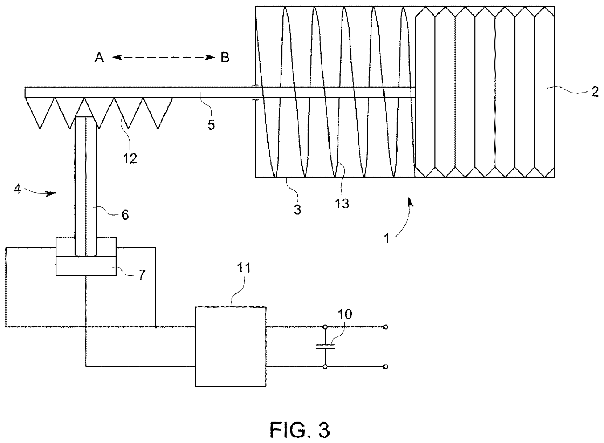

In the system shown in FIGS. 1 and 2, the piezoelectric bending element 6 is deformed when the bellow 2 moves the piston 5 in the direction "A" and returns to its original shape when the bellow 2 moves the piston 5 in the direction "B". FIG. 3 shows a power generator system according to the present invention, with which the number of deformations per movement is increased. In FIG. 3, the piston 5 comprises notches 12, in which the piezoelectric bending element 6 snaps when the piston 5 is moved in the direction "A" or "B". In this way, a plurality of individual movements are applied to the piezoelectric element 6 during a long expansions/contraction period (stroke) is generated, wherein the piston 5 and the notches 12 form a mechanical converter that converts the movement of one stroke continuously applied by the expanding or contracting bellow 2 into a reciprocal movement of the piezoelectric element 6.

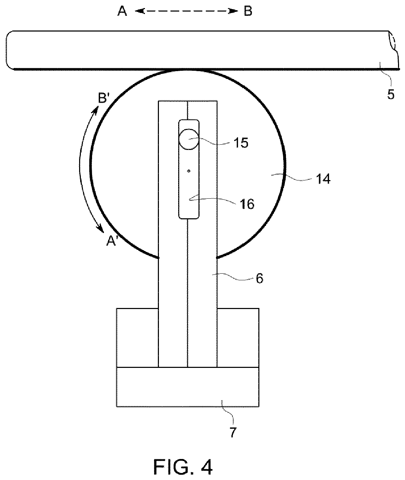

FIG. 4 shows another example of the mechanical converter that comprises an eccentric drive formed of a gearwheel 14 rotated by the linear movement of the piston 5 and a shaft 15 that is eccentrically mounted on the gearwheel 14 und that is inserted in an oblong hole 16 of the piezoelectric element 6. The axis of the gearwheel 14 is fixed and the piezoelectric element 6 is bent back and forth in the directions A and B, when the gearwheel 14 is driven by the piston 5 und rotates in the direction A' or B'.

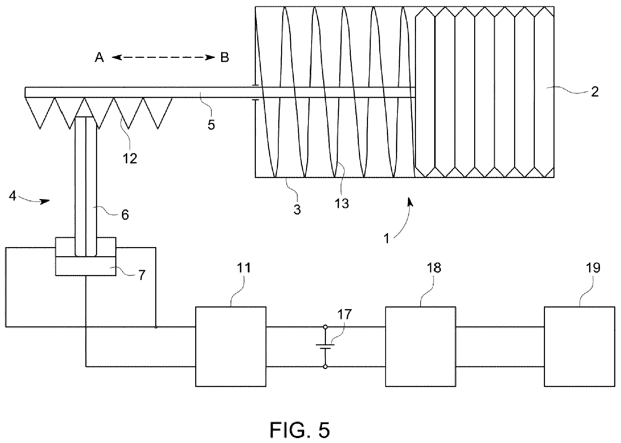

FIG. 5 shows a sensor device according to yet another embodiment of the present invention. The sensor device comprises the power generator system shown in FIG. 3, in which a battery 17 is used as energy storage means instead of the capacitor 10, a temperature sensor 18 and a near-field communication (NFC) unit 19. The temperature sensor 18 is supplied with power generated by the generator system as described above, measures ambient temperature of the sensor device at regular time intervals, and outputs the measured temperature to the NFC unit 19. The NFC unit 19 stores the temperature values together with the date and time of the measurement and transmits the stored data to an electronic device (smartphone or tablet) that request the data using NFC. The NFC unit 19 can be powered by the generator system or collect energy from the interrogating radio waves.

Alternately, the sensor device can comprise the generator system shown in FIG. 1 and/or the temperature sensor 18 can measure the temperature only at the time the level of energy generated by the generator system exceeds a minimum level, which corresponds to a minimum temperature change.

Alternatively or in addition, the sensor device can comprise an air pressure sensor, humidity sensor, brightness sensor, motion detector and/or a switch that is controlled by the sensor/detector and with which an external device (fan or lamp) is switched on or off.

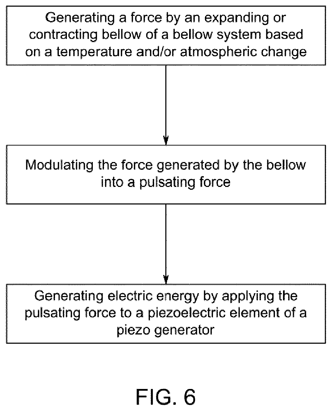

FIG. 6 shows a very simplistic flowchart showing the single steps performed by the realisation of the method described in detail above.

## Claims

1. System for generating electric energy, comprising
a bellows system (1) configured to expand or contract a bellows (2) of the bellows system (1) based on changes of environmental conditions, in particular temperature changes and/or atmospheric pressure changes;
a piezo generator (4) configured to generate said electric energy by a piezoelectric element (6) elastically deformable by the movement of the expanding or contracting bellows (2),
a capacitor (10) or a battery (17) for storing the electric energy generated by the piezo generator (4); and
a charging unit (11) for charging the capacitor (10) or the battery (17) by the generated electric energy,
**characterized by**
a control unit for controlling the charging unit (11), wherein the control unit is configured to activate the charging when the energy stored in the capacitor (10) or the battery (17) falls below a second threshold and deactivate the charging when the energy stored in the capacitor (10) or the battery (17) exceeds a third threshold, wherein
the control unit is configured to predict or receive a temporal profile of a power consumption of a device (18) connected to the capacitor (10) or the battery (17) and the energy generated by the piezo generator (4), wherein the temporal profile indicates an expected power consumption of the device (18) and the energy generated by the piezo generator (4) over a period of time; and
the control unit is configured to set the second threshold and third threshold based on the temporal profile in order to match energy requirements of the device and the available energy of the system each time.

2. System according to claim 1, wherein
the bellows system (1) comprises a hermetically sealed bellows (2) that includes gas and/or liquid.

3. System according to claim 2, wherein
the bellows (2) include a liquid having a boiling point under normal conditions in the range of 8°C to i6°C, preferred in the range of 10°C to 14°C, and most preferred is ethyl chloride having a boiling temperature of 12°C.

4. System according to anyone of claims 1 to 3, further comprising a return spring (13) actuating the piezoelectric element (6) and/or the bellows (2).

5. System according to anyone of claims 1 to 4, further comprising a mechanical converter (5,12, 14, 15) comprising an input member (5) connected to the bellows (2) and moveable by the expanding or contracting bellows (2), wherein the mechanical converter is configured to convert a linear movement of the input member (5) in one direction into a reciprocal movement and to apply the pulsating force to an output member.

6. System according to anyone of claims 1 to 5, wherein the control unit is configured to activate the charging when the level of the electric energy generated by the piezo generator (4) exceeds a first threshold.

7. Sensor device comprising a system according to anyone of claims 1 to 6.

8. Method for generating electric energy, comprising the steps of:
generating a movement by an expanding or contracting bellows of a bellows system (1) based on changes of environmental conditions, in particular temperature and/or atmospheric pressure changes;
generating said electric energy by applying said movement to a piezoelectric element (6) of a piezo generator (4); and
charging a capacitor (10) or a battery (17) by the generated electric energy, **characterized by**
predicting or receiving a temporal profile of a power consumption of a device (18) connected to the capacitor (10) or the battery (17) and the energy generated by the piezo generator (4), wherein the temporal profile indicates the expected power consumption of the device (18) and the energy generated by the piezo generator (4) over a period of time; and
setting a second threshold and/or third threshold based on the temporal profile in order to match the energy requirements of the device (18) and the available energy of the system each time; wherein
in the charging step, charging is activated when the energy stored in the capacitor (10) or the battery (17) falls below the second threshold and is deactivated when the energy stored in the capacitor (10) or the battery (17) exceeds the third threshold.

9. The method according to claim 8, wherein
a reciprocal movement is applied to the piezoelectric element (6); and the method further comprises the step of
modulating the movement generated by the bellows (2) into said reciprocal movement.

10. The method according to claim 8 or 9, further comprises the step of:
activating charging when the level of the electric energy generated by the piezo generator (4) exceeds a first threshold.

## Patentansprüche

1. System zur Erzeugung elektrischer Energie, umfassend
ein Balgsystem (1), das konfiguriert ist, um einen Balg (2) des Balgsystems (1) basierend auf Änderungen der Umgebungsbedingungen, insbesondere Temperaturänderungen und/oder Änderungen des atmosphärischen Drucks, auszudehnen oder zusammenzuziehen;
einen Piezo-Generator (4), der konfiguriert ist, um die elektrische Energie durch ein piezoelektrisches Element (6) zu erzeugen, das durch die Bewegung des sich ausdehnenden oder zusammenziehenden Balgs (2) elastisch verformbar ist,
einen Kondensator (10) oder eine Batterie (17) zum Speichern der durch den Piezo-Generator (4) erzeugten elektrischen Energie; und
eine Ladeeinheit (11) zum Laden des Kondensators (10) oder der Batterie (17) durch die erzeugte elektrische Energie,
**gekennzeichnet durch**
eine Steuereinheit zum Steuern der Ladeeinheit (11), wobei die Steuereinheit konfiguriert ist, das Laden zu aktivieren, wenn die in dem Kondensator (10) oder der Batterie (17) gespeicherte Energie unter einen zweiten Schwellenwert fällt, und das Laden zu deaktivieren, wenn die in dem Kondensator (10) oder der Batterie (17) gespeicherte Energie einen dritten Schwellenwert überschreitet, wobei
die Steuereinheit konfiguriert ist, um ein zeitliches Profil eines Stromverbrauchs einer Vorrichtung (18), die mit dem Kondensator (10) oder der Batterie (17) verbunden ist, und der von dem Piezo-Generator (4) erzeugten Energie zu prognostizieren oder zu empfangen, wobei das zeitliche Profil einen erwarteten Stromverbrauch der Vorrichtung (18) und der von dem Piezo-Generator (4) erzeugten Energie über einen Zeitraum angibt; und die Steuereinheit konfiguriert ist, um den zweiten Schwellenwert und den dritten Schwellenwert basierend auf dem zeitlichen Profil einzustellen, um die Energieanforderungen der Vorrichtung und die verfügbare Energie des Systems jedes Mal anzupassen.

2. System nach Anspruch 1, wobei
das Balgsystem (1) einen hermetisch abgedichteten Balg (2) umfasst, der Gas und/oder Flüssigkeit einschließt.

3. System nach Anspruch 2, wobei
der Faltenbalg (2) eine Flüssigkeit einschließt, die unter normalen Bedingungen einen Siedepunkt im Bereich von 8 °C bis 16 °C, bevorzugt im Bereich von 10 °C bis 14 °C, aufweist, und am meisten bevorzugt Ethylchlorid mit einer Siedetemperatur von 12 °C ist.

4. System nach einem der Ansprüche 1 bis 3, ferner umfassend
eine Rückstellfeder (13), die das piezoelektrische Element (6) und/oder den Balg (2) betätigt.

5. System nach einem der Ansprüche 1 bis 4, ferner umfassend
einen mechanischen Wandler (5, 12, 14, 15), der ein mit dem Balg (2) verbundenes und durch den sich ausdehnenden oder zusammenziehenden Balg (2) bewegliches Eingangselement (5) umfasst, wobei der mechanische Wandler konfiguriert ist, um eine lineare Bewegung des Eingangselements (5) in einer Richtung in eine Hin- und Herbewegung umzuwandeln und die pulsierende Kraft auf ein Ausgangselement auszuüben.

6. System nach einem der Ansprüche 1 bis 5, wobei
die Steuereinheit konfiguriert ist, um das Laden zu aktivieren, wenn der Pegel der von dem Piezogenerator (4) erzeugten elektrischen Energie einen ersten Schwellenwert überschreitet.

7. Sensorvorrichtung, umfassend ein System nach einem der Ansprüche 1 bis 6.

8. Verfahren zur Erzeugung elektrischer Energie, umfassend die Schritte:
Erzeugen einer Bewegung durch einen sich ausdehnenden oder zusammenziehenden Balg eines Balgsystems (1) basierend auf Änderungen der Umgebungsbedingungen,
insbesondere Änderungen der Temperatur und/oder des atmosphärischen Drucks;
Erzeugen der elektrischen Energie durch Anwenden der Bewegung auf ein piezoelektrisches Element (6) eines Piezogenerators (4); und
Laden eines Kondensators (10) oder einer Batterie (17) durch die erzeugte elektrische Energie,
**gekennzeichnet durch**
Prognostizieren oder Empfangen eines zeitlichen Profils eines Stromverbrauchs einer mit dem Kondensator (10) oder der Batterie (17) verbundenen Vorrichtung (18) und der von dem Piezo-Generator (4) erzeugten Energie, wobei das zeitliche Profil den erwarteten Stromverbrauch der Vorrichtung (18) und der von dem Piezo-Generator (4) erzeugten Energie über einen Zeitraum angibt; und
Einstellen eines zweiten Schwellenwerts und/oder eines dritten Schwellenwerts basierend auf dem zeitlichen Profil, um die Energieanforderungen der Vorrichtung (18) und die verfügbare Energie des Systems jedes Mal anzupassen; wobei
im Schritt des Ladens das Laden aktiviert wird, wenn die im Kondensator (10) oder in der Batterie (17) gespeicherte Energie unter den zweiten Schwellenwert fällt, und deaktiviert wird, wenn die im Kondensator (10) oder in der Batterie (17) gespeicherte Energie den dritten Schwellenwert überschreitet.

9. Verfahren nach Anspruch 8, wobei
eine Hin- und Herbewegung auf das piezoelektrische Element (6) ausgeübt wird; und das Verfahren ferner den folgenden Schritt umfasst:
Modulieren der durch den Balg (2) erzeugten Bewegung in die Hin- und Herbewegung.

10. Verfahren nach Anspruch 8 oder 9, ferner umfassend den folgenden Schritt:
Aktivieren des Ladens, wenn der Pegel der von dem Piezogenerator (4) erzeugten elektrischen Energie einen ersten Schwellenwert überschreitet.

## Revendications

1. Système pour générer de l'énergie électrique, comprenant
un système de soufflet (1) conçu pour étendre ou contracter un soufflet (2) du système de soufflet (1) sur la base de changements de conditions environnementales, en particulier des changements de température et/ou des changements de pression atmosphérique ;
un générateur piézoélectrique (4) conçu pour générer ladite énergie électrique par un élément piézoélectrique (6) élastiquement déformable par le mouvement du soufflet (2) s'étendant ou se contractant,
un condensateur (10) ou une batterie (17) pour stocker l'énergie électrique générée par le générateur piézoélectrique (4) ; et
une unité de chargement (11) pour charger le condensateur (10) ou la batterie (17) par l'énergie électrique générée,
**caractérisé par**
une unité de commande pour commander l'unité de chargement (11), dans lequel l'unité de commande est configurée pour activer le chargement lorsque l'énergie stockée dans le condensateur (10) ou la batterie (17) descend en dessous d'un deuxième seuil et désactiver le chargement lorsque l'énergie stockée dans le condensateur (10) ou la batterie (17) dépasse un troisième seuil, dans lequel
l'unité de commande est configurée pour prédire ou recevoir un profil temporel d'une consommation de puissance d'un dispositif (18) connecté au condensateur (10) ou à la batterie (17) et de l'énergie générée par le générateur piézoélectrique (4), dans lequel le profil temporel indique une consommation de puissance attendue du dispositif (18) et l'énergie générée par le générateur piézoélectrique (4) sur une période de temps ; et
l'unité de commande est configurée pour définir le deuxième seuil et le troisième seuil sur la base du profil temporel afin de faire correspondre les exigences énergétiques du dispositif et l'énergie disponible du système à chaque moment.

2. Système selon la revendication 1, dans lequel
le système de soufflet (1) comprend un soufflet hermétiquement scellé (2) qui inclut un gaz et/ou un liquide.

3. Système selon la revendication 2, dans lequel
le soufflet (2) inclut un liquide ayant un point d'ébullition dans des conditions normales dans la plage de 8 °C à 16 °C, de préférence dans la plage de 10 °C à 14 °C et le plus préférablement est du chlorure d'éthyle ayant une température d'ébullition de 12 °C.

4. Système selon l'une quelconque des revendications 1 à 3, comprenant en outre
un ressort de rappel (13) actionnant l'élément piézoélectrique (6) et/ou le soufflet (2).

5. Système selon l'une quelconque des revendications 1 à 4, comprenant en outre
un convertisseur mécanique (5, 12, 14, 15) comprenant un élément d'entrée (5) connecté au soufflet (2) et mobile par le soufflet (2) s'étendant ou se contractant, dans lequel le convertisseur mécanique est conçu pour convertir un mouvement linéaire de l'élément d'entrée (5) dans une direction en un mouvement de va-et-vient et pour appliquer la force pulsatoire à un élément de sortie.

6. Système selon l'une quelconque des revendications 1 à 5, dans lequel
l'unité de commande est configurée pour activer le chargement lorsque le niveau de l'énergie électrique générée par le générateur piézoélectrique (4) dépasse un premier seuil.

7. Dispositif capteur comprenant un système selon l'une quelconque des revendications 1 à 6.

8. Procédé pour générer de l'énergie électrique, comprenant les étapes consistant à :
générer un mouvement par un soufflet s'étendant ou se contractant d'un système de soufflet (1) sur la base de changements de conditions environnementales, en particulier des changements de température et/ou de pression atmosphérique ;
générer ladite énergie électrique en appliquant ledit mouvement à un élément piézoélectrique (6) d'un générateur piézoélectrique (4) ; et
charger un condensateur (10) ou une batterie (17) par l'énergie électrique générée,
**caractérisé par**
la prévision ou la réception d'un profil temporel d'une consommation de puissance d'un dispositif (18) connecté au condensateur (10) ou à la batterie (17) et de l'énergie générée par le générateur piézoélectrique (4), dans lequel le profil temporel indique la consommation de puissance attendue du dispositif (18) et l'énergie générée par le générateur piézoélectrique (4) sur une période de temps ; et
la définition d'un deuxième seuil et/ou d'un troisième seuil sur la base du profil temporel afin de faire correspondre les exigences énergétiques du dispositif (18) et l'énergie disponible du système à chaque fois ; dans lequel
dans l'étape de chargement, le chargement est activé lorsque l'énergie stockée dans le condensateur (10) ou la batterie (17) descend en dessous du deuxième seuil et est désactivé lorsque l'énergie stockée dans le condensateur (10) ou la batterie (17) dépasse le troisième seuil.

9. Procédé selon la revendication 8, dans lequel
un mouvement de va-et-vient est appliqué à l'élément piézoélectrique (6) ; et le procédé comprend en outre l'étape consistant à
moduler le mouvement généré par le soufflet (2) en ledit mouvement de va-et-vient.

10. Procédé selon la revendication 8 ou 9, comprend en outre l'étape consistant à :
activer le chargement lorsque le niveau de l'énergie électrique générée par le générateur piézoélectrique (4) dépasse un premier seuil.
